Europäisches Patentamt

**European Patent Office**

Office européen des brevets

(11) Veröffentlichungsnummer : **0 030 286**
**B1**

(12) **EUROPÄISCHE PATENTSCHRIFT**

(45) Veröffentlichungstag der Patentschrift :
09.09.87

(51) Int. Cl.⁴ : **H 01 L 21/76, H 01 L 21/31**

(21) Anmeldenummer : **80107092.1**

(22) Anmeldetag : **15.11.80**

(54) Dielektrisch isoliertes Halbleiterbauelement und Verfahren zur Herstellung.

(30) Priorität : **23.11.79 BE 258227**

(43) Veröffentlichungstag der Anmeldung :
**17.06.81 Patentblatt 81/24**

(45) Bekanntmachung des Hinweises auf die Patenterteilung : **09.09.87 Patentblatt 87/37**

(84) Benannte Vertragsstaaten :
**DE FR GB IT**

(56) Entgegenhaltungen :
FR-A- 1 597 033
US-A- 3 403 439
ELECTRONIC LETTERS, Band 15, Nr. 14, Juli 1979, Seiten 435-437, Hitchin, GB, A.F. TASCH et al.: "Silicon-on-insulator MOSFETS fabricated on laserannealed polysilicon on SiO2"
Halbleiter-Technolgie", v. I. RUGE, SPRINGER-Verlag, Berlin-Heidelberg-New York 1975, Seiten 322-323

(73) Patentinhaber : **Alcatel N.V.**
**De Lairessestraat 153**
**NL-1075 HK Amsterdam (NL)**

(72) Erfinder : **Mattheus, Walter Hendrik Anna**
**Frans Schollaertsstraat 16**
**B-3200 Kessel-LO (BE)**

(74) Vertreter : **Graf, Georg Hugo, Dipl.-Ing. et al**
**c/o Standard Elektrik Lorenz AG Patent- und Lizenzwesen Postfach 30 09 29 Kurze Strasse 8**
**D-7000 Stuttgart 30 (DE)**

**Beschreibung**

Die Priorität der Anmeldung Nr. 25 82 77 vom 23.11.1979 in Belgien wird beansprucht.

Die vorliegende Erfindung betrifft ein Verfahren zur Herstellung eines Halbleiterbauelements, bei dem eine elektrisch isolierte Schicht zwischen einer einkristallinen Schicht und einer Schicht aus kristallinem Material angeordnet ist.

Aus « Journal of the Electrochemical Society », Vol 124, Nr. 1, Januar 1977, Seiten 5C bis 12C ist ein Halbleiterbauelement sowie ein Verfahren zur Herstellung desselben bekannt, wobei auf der Oberfläche eines Substrats oder Wafers aus einkristallinem Silicium V-förmige Einschnitte ausgebildet werden, worauf durch Oxidation der Oberfläche eine elektrisch isolierende Schicht erzeugt wird, dann ein Körper aus polykristallinem Silicium auf der Isolierschicht abgeschieden wird und schließlich Teile des Substrats abgetragen werden, so daß eine Vielzahl von Isolierwannen in der elektrisch isolierenden Schicht entstehen, wobei diese Wannen Inseln aus einkristallinem Silicium enthalten, die gegenüber dem Körper aus polykristallinem Silicium elektrisch isoliert sind. Man erhält somit ein Halbleiterbauelement, bei dem Inseln aus einkristallinem Silicium durch Isolierwannen gegenüber dem Körper aus polykristallinem Silicium isoliert sind.

Wie in dem genannten Artikel erwähnt wird, hat es sich gezeigt, daß die Halbleiterscheibe während der Herstellung eine gewisse Verbiegung erleiden kann, möglicherweise bedingt durch die thermische Behandlung, der sie unterworfen wird, so daß nachfolgende Operationen zu einem defekten Halbleiterbauelement führen können, bedingt z. B. durch das Vorhandensein von elektrisch nicht isolierten Zonen und durch Spannung im Kristallgitter.

In dem Artikel « A new technology für dielectric isolation » von Y. Sumitomo et al, in « Semiconductor Silicon » 1973 H.R. Huff und R.R. Burgess, Editors, pp 893-904, The Electrochemical Society Softbound Symposium Series, Princeton, New Jersey (1973) wird bereits ein Verfahren zur Herstellung eines Halbleiterbauelements beschrieben, bei dem eine elektrisch isolierende Schicht zwischen einer ersten Schicht aus kristallinem Material und einer zweiten Schicht aus polykristallinem Silicium gebildet wird, die mit einer geringen Menge an Sauerstoff dotiert ist, um während der Abscheidung des polykristallinem Siliciums ein Verbiegen der Halbleiterscheibe zu vermeiden.

Ein Nachteil dieses bekannten Verfahrens liegt darin, daß der Dotiervorgang ein verhältnismäßig kritischer Prozeß ist.

Der vorliegenden Erfindung liegt deshalb die Aufgabe zugrunde, ein Verfahren zur Herstellung eines Halbleiterbauelements der eingangs genannten Art so auzubilden, daß bei der weiteren Verarbeitung keine Verbiegung eintritt. Die Aufgabe wird durch das kennzeichnende Merkmal des Patentanspruchs gelöst.

Ein Merkmal des Halbleiterbauelements nach dem Verfahren der vorliegenden Erfindung besteht darin, daß das weitgehend einkristalline Material der zweiten Schicht einen thermischen Ausdehnungskoeffizienten besitzt, der weitgehend mit dem des vornehmlich einkristallinen Materials der ersten Schicht übereinstimmt.

Ein weiteres Merkmal der Erfindung besteht darin, daß die beiden genannten Schichten aus dem gleichen Material bestehen.

Aufgrund der Tatsache, daß die beiden Schichten, die die Isolierschicht einschließen, aus dem gleichen Material bestehen und weitgehend die gleiche einkristalline Struktur aufweisen, ergibt sich für sie der gleiche thermische Ausdehnungskoeffizient, so daß die Halbleiterscheibe weitgehend plan bleibt, wenn sie während der Verarbeitung der Einwirkung von Hitze unterworfen wird.

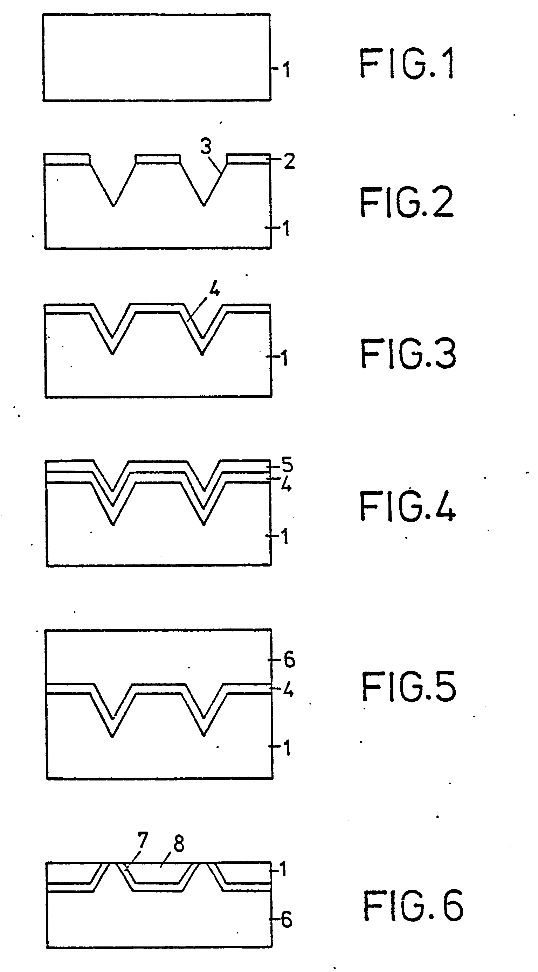

Die Erfindung wird nunmehr anhand der beigefügten Fig. 1 bis 6 erläutert, die im Schnitt eine Schrittfolge von Verfahrensstufen zur Herstellung eines Halbleiterbauelements nach dem Verfahren der Erfindung darstellen.

Ausgegangen wird von einem einkristallinen Siliciumsubstrat oder Siliciumscheibe 1 vom n-Leitfähigkeitstyp und der Kristallorientierung 100 (Fig. 1). Die Oberfläche wird dann unter Bildung eines elektrisch isolierenden Siliciumdioxidfilmes 2 oxidiert (Fig. 2), worauf unter Zuhilfenahme einer entsprechenden Maske das Oxid in einem bestimmten Muster entfernt wird. Im Anschluß daran wird das so freigelegte Silicium in Abhängigkeit von der Kristallorientierung geätzt, wobei der Angriff in 100·-Richtung schneller vonstatten geht als in ·111·-Richtung. Diese gezielte Ätzung führt zur Bildung von « V-förmigen » Einschnitten 3 in der Oberfläche der Scheibe. Die Tiefe der Einschnitte ist ein Bruchteil der Gesamtstärke der Halbleiterscheibe. Nach dem Ätzvorgang wird eine elektrisch isolierende Schicht (Fig. 3) aus Siliciumdioxid auf der gesamten Scheibenoberfläche aufwachsengelassen. Vor diesem Oxidationsschritt kann der Oxidfilm 2 ggf. entfernt werden.

Ein Film 5 aus polykristallinem Silicium wird dann auf der Oxidschicht 4 abgelagert (Fig. 4), die Stärke dieses Films liegt z. B. bei 1 μm. Der polykristalline Siliciumfilm 5 wird dann einer Temperaturbehandlung durch Laserbestrahlung unterworfen, wodurch er in den kristallinen Zustand übergeführt wird und somit zu einem weitgehend einkristallinen Film wird, der weitgehend identisch ist mit dem Material der Halbleiterscheibe oder Substrat 1.

Eine Schicht 6 aus einkristallinem Silicium wird dann epitaktisch auf dem einkristallinem Siliciumfilm 5 abgeschieden (Fig. 6). Da das Material der Schicht 6 dem des Substrats 1 weitgehend entspricht, und zwar vom Gesichtspunkt der Kristallstruktur und der Zusammensetzung, haben diese beiden Materialien angenähert den gleichen Ausdehnungskoeffizient, so daß während des ganzen Prozesses keine Verbiegung der Halbleiterscheibe auftritt.

Zum Schluß wird die Halbleiterscheibe umgedreht und das einkristalline Substrat 1 zuerst abgeschliffen, bis die Isolierschicht 4 freigelegt ist und dann poliert. Auf diese Weise werden Isolierwannen 7 (Fig. 6) ausgebildet, die Inseln 8 aus einkristallinem Silicium vom n-Leitungstyp enthalten, die gegenüber dem einkristallinen Siliciumkörper 6 elektrisch isoliert sind.

Nach dem Polieren kann die Scheibe den weiteren üblichen Verfahrensschritten zur Herstellung eines Halbleiterbauelements unterworfen werden.

Ein nach dem vorliegenden Verfahren hergestelltes Bauelement unterscheidet sich von einem Bauelement, das nach den oben in Verbindung mit der Sauerstoffdotierung genannten Verfahren hergestellt wurde, nicht nur dadurch, daß bei letzterem die zweite Schicht aus polykristallinem Material besteht und nicht aus einkristallinem, wie bei der vorliegenden Erfindung, sondern auch noch dadurch, daß die erste Schicht, die auch dort aus einkristallinem Material ist, neben diesem noch einen verhältnismäßig hohen Anteil an polykristallinem Material enthält.

## Patentanspruch

Verfahren zum Herstellen eines Halbleiterbauelements, wobei auf der Oberfläche eines einkristallinen Siliciumsubstrats (1) V-förmige Einschnitte (3) ausgebildet werden, durch Oxidation der Oberfläche eine elektrisch isolierende Siliciumdioxidschicht (4) erzeugt wird, auf dieser eine Polysiliciumschicht (5) abgeschieden und ein Teil des Siliciumsubstrats (1) unter Ausbildung von Isolierwannen (7) in der Siliciumdioxidschicht (4) abgetragen wird, dadurch gekennzeichnet, daß die Polysiliciumschicht (5) thermisch durch Laserbestrahlung in eine Schicht aus einkristallinem Silicium umgewandelt und auf dieser einkristallines Silicium epitaktisch unter Ausbildung einer Schicht (6) abgeschieden wird.

## Claim

Process for manufacturing a semiconductor device, according to which on the surface of a single crystalline silicon substrat (1) v-shaped recesses (3) are formed, by oxydation of the surface an electrically insolating SiO$_2$-layer (4) is build, a polysilicon layer (5) is deposited thereon and a part of said silicon substrat (1) is removed building insolating wells (7) in the silicon layer (4), characterized in that the polysilicon layer (5) is thermically changed to a layer of single crystalline silicon by laser irridation and a single crystalline layer is expitaxially deposited theron building a layer (6).

## Revendication

Procédé de fabrication d'un dispositif semiconducteur selon lequel, dans la surface d'un substrat de silicium monocristallin sont formées des entailles en V (3), une couche de dioxyde de silicium électriquement isolante est produite par oxydation de la surface, une couche de silicium polycristallin (5) est déposée sur cette couche et une partie du substrat de silicium (1) est arrasée, pour la formation de cuvettes isolées dans la couche de dioxyde de silicium, caractérisé en ce que la couche de silicium polycristallin (5) est convertie thermiquement, par rayonnement laser, en une couche de silicium monocristallin et, sur cette couche, du silicium monocristallin est déposé par épitaxie, pour la formation d'une couche (6).

FIG.1

FIG.2

FIG.3

FIG.4

FIG.5

FIG.6